**Europäisches Patentamt**

(19) **European Patent Office**

**Office européen des brevets**

(11) Numéro de publication: **0 159 233**

**B1**

(12) **FASCICULE DE BREVET EUROPÉEN**

(45) Date de publication du fascicule du brevet:
13.01.88

(21) Numéro de dépôt: **85400505.5**

(22) Date de dépôt: **15.03.85**

(51) Int. Cl.⁴: **H 03 K 17/04,** H 03 K 17/64

(54) Circuit de commande de commutation d'un transistor de puissance.

(30) Priorité: **16.03.84 FR 8404112**

(43) Date de publication de la demande:
**23.10.85 Bulletin 85/43**

(45) Mention de la délivrance du brevet:
**13.01.88 Bulletin 88/2**

(84) Etats contractants désignés:
**DE FR GB IT NL**

(56) Documents cité:
**DE-A-3 230 236**
**US-A-4 323 825**

**IBM TECHNICAL DISCLOSURE BULLETIN, vol. 17,
no. 4, septembre 1974, pages 1091-1092, New York,
US; K.H. KNICKMEYER: "Dynamic transistor
antisaturation control"**

(73) Titulaire: **THOMSON- CSF, 173, Boulevard
Haussmann, F-75379 Paris Cédex 08 (FR)**

(72) Inventeur: **de Sartre, Jean, THOMSON- CSF SCPI
173, bld Haussmann, F-75379 Paris Cedex 08 (FR)**

(74) Mandataire: **Guérin, Michel, THOMSON- CSF SCPI
19, avenue de Messine, F-75008 Paris (FR)**

## Description

La présente invention concerne les circuits de commutation de courants et tensions relativement élevées, et plus particulièrement ceux qui doivent effectuer une commutation de courant dans une charge essentiellement inductive.

On s'intéresse notamment aux circuits de commande de commutation des alimentations à découpage et aux circuits de commande de balayage horizontal ou vertical des récepteurs de télévision.

Dans ces circuits, l'élément de commutation est un transistor de puissance dont le collecteur est relié à une charge fortement inductive comprenant essentiellement des enroulements de transformateurs (pour les alimentations à découpage) ou une bobine de déviation horizontale ou verticale de faisceau électronique (pour les circuits de balayage).

Le plus souvent, la base du transistor de puissance est commandée par un circuit fournissant des créneaux de commande périodique, de largeur variable.

Au niveau haut des créneaux, un courant de base est appliqué pour rendre le transistor conducteur; au niveau bas, ce courant est interrompu pour bloquer le transistor.

Le transistor doit pouvoir conduire un courant important, qui croît d'ailleurs linéairement d'une valeur minimale a une valeur maximale, à chaque période de commutation, lorsque la charge est inductive. Pour que le transistor puisse conduire le courant maximal prévu à la fin de la période de conduction (courant de déviation maximale du faisceau électronique dans le cas du balayage d'un récepteur de télévision), il est nécessaire d'appliquer un courant largement suffisant à la base de ce transistor pendant la période de conduction.

Lorsqu'un créneau est appliqué avec un tel courant de base largement calculé, il en résulte une forte saturation du transistor, ce qui nuit à la rapidité de son blocage à la fin de la période de conduction: le transistor fortement saturé ne pourra pas interrompre rapidement le courant qui le traverse, malgré l'interruption du courant appliqué à sa base.

Il est d'ailleurs maintenant habituel de prévoir que le blocage du transistor est accéléré par l'application d'une forte impulsion de courant de base négatif légèrement après l'interruption du créneau qui commande l'application d'un courant de base positif.

D'autre part, en dehors de l'instant de blocage du transistor, le créneau de commande de conduction des dispositifs habituels établit un courant de base positif (de maintien en conduction) qui garde pendant toute la durée de conduction désirée une valeur constante égale au moins au courant maximal nécessaire à la fin de la priode de conduction; un tel courant de base important n'est pas du tout nécessaire au début de la mise en conduction et il conduit à une consommation de puissance tout à fait inutile.

La présente invention propose un circuit qui évite cette forte saturation et cette consommation inutile de courant de base, du fait qu'il ajuste au mieux, à chaque instant, le courant de base, en lui donnant la valeur nécessaire compte-tenu du courant principal qui doit parcourir le transistor de puissance à cet instant.

Le circuit selon l'invention, pour la commande de commutation d'un transistor de puisance en série avec une charge essentiellement inductive, comprend un générateur de créneaux de largeur variable, une première résistance de faible valeur, une deuxième résistance de valeur beaucoup plus importante, deux ensembles de transistors constituant essentiellement des miroirs de courant comportant chacun un premier transistor monté en diode et un deuxième transistor de recopie, les deux transistors, de même type NPN ou PNP dans un même ensemble et de type opposé à ceux de l'autre ensemble, ayant leurs bases réunies, la première résistance étant reliée d'une part à l'émetteur du transistor de puissance et d'autre part, à la deuxième résistance qui est par ailleurs reliée a l'émetteur du transistor de recopie du premier miroir de courant; le premier transistor du premier miroir de courant a son émetteur relié à l'émetteur du transistor de puissance et a son collecteur en série avec une source de courant commandée en tout ou rien par le générateur de créneaux; le collecteur du transistor de recopie du premier miroir de courant est relié au collecteur du premier transistor du deuxième miroir de courant; les émetteurs des premier et deuxième transistors du deuxième miroir de courant sont réunis mais non ceux du premier miroir, et le collecteur du deuxième miroir de courant est relié à une entrée d'un amplificateur de courant dont la sortie est reliée à la base du transistor de puissance.

On expliquera plus loin le fonctionnement détaillé de ce circuit, mais d'ores et déjà, on peut mentionner que seul le deuxième miroir de courant est un vrai miroir de courant (transistors ayant leurs bases réunies et leurs émetteurs réunis). Le premier agit comme miroir de courant seulement au début de la période de conduction du transistor de puissance; les émetteurs des transistors de ce miroir ne sont d'ailleurs pas réunis.

Pour l'essentiel, le circuit fonctionne de la manière suivante: au début d'un créneau de mise en conduction du transistor de puissance, engendré par le générateur de créneaux de largeur variable, un faible courant est établi dans le premier miroir de courant. Ce courant est amplifié par l'amplificateur de courant qui commence alors à faire conduire le transistor de puissance. La croissance du courant dans ce transistor est ensuite dictée par le caractère inductif de la charge, et cette croissance induit dans la résistance de faible valeur une chute de tension qui se répercute dans la résistance de forte valeur et qui induit à son tour une croissance du courant à l'entrée de l'amplificateur de courant commandant le transistor de puissance. La croissance du courant de commande de ce dernier suit donc exactement les besoins dictés par la consommation croissante de courant dans la charge inductive. Il n'y a ni sursaturation du transistor de puissance ni consommation excessive de courant de base pendant la durée de conduction.

D'autres caractéristiques et avantages de l'invention apparaîtront à la lecture de la description détaillée qui suit et qui est faite en référence aux dessins annexés dans lesquels:

- la figure 1 représente un schéma de circuit de commande conforme à l'invention,
- la figure 2 représente en détail un mode de réalisation de la source de courant commandée de la figure 1,
- la figure 3 représente en détail un exemple de réalisation de l'amplificateur de courant de la figure 1.

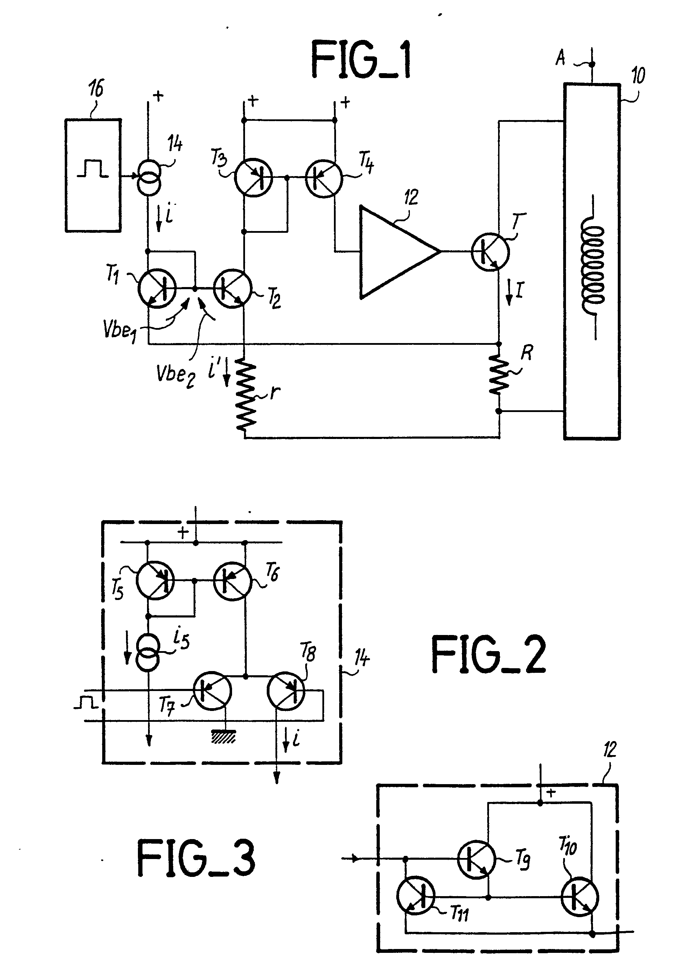

Le circuit selon l'invention comprend (figure 1) un transistor de puissance T pour la commutation d'un courant dans une charge essentiellement inductive qui a été représentee sous forme d'un bloc 10 relié d'une part au collecteur du transistor T, d'autre part, par l'intermédiaire d'une résistance de faible valeur R, à son émetteur, et enfin à une source de tension de polarisation (borne A) fournissant l'énergie nécessaire à l'alimentation de la charge 10. Dans ce qui suit on considèrera que le transistor T est de type NPN. Sinon, il faut inverser les polarités.

A titre d'exemple, le bloc 10 comprend simplement le primaire d'un transformateur, pour une alimentation à découpage, ce primaire étant en série entre le collecteur du transistor T et la borne positive A d'alimentation, la résistance R étant reliée à une borne négative de l'alimentation. Pour un circuit de balayage de télévision, le bloc 10 peut comprendre en outre une bobine de déviation essentiellement en parallèle avec le primaire du transformateur (qui est alors le transformateur dit de ligne). On notera que la résistance R peut être la résistance série souvent utilisée à cet endroit comme détecteur de courant pour fournir un signal de dépassement de courant à un circuit de protection du transistor T.

La base du transistor T est commandée par un amplificateur de courant 12 fournissant un courant de sortie essentiellement proportionnel à son courant d'entrée.

Un premier ensemble de deux transistors NPN T1 et T2 ayant leurs bases réunies constitue ce qu'on appellera dans la suite de la description et dans les revendications un "miroir de courant", et un deuxième ensemble de deux transistors PNP T3 et T4 ayant leurs bases réunies constitue un second miroir de courant. En fait, seul le deuxième ensemble constitue un véritable miroir de courant tel que le courant circulant dans le transistor T3 soit recopié par le transistor T4 avec un facteur de proportionalité dépendant uniquement des rapport de surfaces d'émetteur des transistors T3 et T4. L'ensemble T1, T2 ressemble à un miroir de courant sans en être tout à fait un.

Les transistors T3 et T4 ont leurs émetteurs réunis à une source d'alimentation positive commune qui peut d'ailleurs être la borne A. Le transistor T3 est monté en diode, c'est-à-dire que son collecteur et sa base sont réunis. Le collecteur du transistor T4 (sortie du deuxième miroir de courant) est relié a l'entrée de l'amplificateur de courant 12. Le collecteur du transistor T3 est relié à la sortie du premier miroir de courant, c'est-à-dire au collecteur du transistor T2.

L'émetteur du transistor T2 est relié à une résistance r de valeur beaucoup plus forte que la résistance R (par exemple r est de l'ordre de 100 fois R).

L'autre extrémité de la résistance r est reliée a la résistance R (du côté ou elle est raccordée à la charge 10 donc du côté ou elle n'est pas raccordée a l'émetteur du transistor T).

Le transistor T1 est monté en diode (collecteur relié à sa base) et son collecteur est relié à une source de courant 14, commandée en tout ou rien par un générateur 16 de créneaux de largeur variable couramment utilisé dans les circuits de commande de commutation d'alimentations à découpage.

La source de courant 14 est reliée par ailleurs à une borne d'alimentation positive qui peut être la borne A. La borne négative de l'alimentation peut être connectée soit au point de jonction des résistance R et r, soit à l'émetteur du transistor T.

Le circuit fonctionne de la manière suivante: le transistor de puissance est bloqué pendant la phase 1 d'un créneau issu du générateur 16 (par exemple créneau au niveau bas), et il conduit pendant la phase 2 (créneau au niveau haut).

On appelle i le courant de la source 14, $Vbe_1$ la tension base-émetteur de transistor T1, $Vbe_2$ celle du transistor T2, i' le courant dans la résistance r et I le courant dans l'émetteur du transistor T.

Le courant dans le transistor T1 est soit nul (créneau de commande au niveau bas) et on a alors $Vbe_1 = 0$, soit égal à la valeur nominale i (créneau au niveau haut) et $Vbe_1$ est alors fixé par i.

On peut écrire:

$$Vbe_2 = Vbe_1 + R (I+i) - ri' \qquad (1)$$
$$\text{donc } Vbe_2 = Vbe_1 + Ri + RI - ri' \qquad (2)$$

Les deux premiers termes sont des constantes lorsque le créneau est au niveau haut. Le deuxième exprime une différence de chutes de tension dans les résistance R et r.

Si un accroissement de courant dI se produit du fait du caractère inductif de la charge, il en résultera un accroissement $dVbe_2$ de $Vbe_2$ et par conséquence un accroissement di' du courant i'; $Vbe_1$ et i ne changent pas.

On a alors:

$$(Vbe_2 + dVbe_2) = Vbe_1 + Ri$$
$$+ R(I + dI) - (i' + di') \qquad (3)$$

Des équations (2) et (3) on déduit:

$$dVbe_2 = RdI - rdi' \qquad (4)$$

En fait, $Vbe_2$ varie très peu et on peut pratiquement écrire:

$$RdI = rdi' \qquad (5)$$

Mais, par ailleurs, l'accroissement $dI$ est lié à $di'$ par le gain de boucle résultant du gain du deuxième miroir de courant (qui est un vrai miroir de courant), du gain de l'amplificateur de courant 12, et du gain en courant (courant émetteur/courant base) du transistor T lui-même. Si K est le gain total de la boucle, on a:

$$dI = Kdi' \qquad (6)$$

De (5) et (6) il résulte que:

$$K = r/R \qquad (7)$$

En fait le gain K peut se décomposer en $K = k_1$ $k_2 k_3$, produit de trois gains qui sont respectivement le gain $k_1$ du deuxième miroir de courant T3, T4; le gain $k_2$ de l'amplificateur 12; et le gain en courant $k_3$ du transistor T lui-même.

$k_1$ et $k_2$ sont des constantes car le miroir de courant T3, T4 et l'amplificateur 12 travaillent en régime linéaire.

Au contraire, $k_3$ n'est pas constant: si on est en régime saturé, $k_3$ est égal à 1 (gain dynamique); si on est en régime linéaire, $k_3$ peut être égal à quelques dizaines d'unité. Si on est en quasi saturation, c'est-à-dire au voisinage de la saturation, $k_3$ varie fortement de un à quelques unités.

On a tout intérêt à faire travailler le transistor T dans cette zone de quasi-saturation pour éviter une consommation excessive de courant de base et une difficulté de commutation à l'ouverture.

On choisit donc les gains $k_1$, $k_2$ et le rapport des résistances R et r de telle manière que, du fait de la relation (7), $k_3$ prenne une valeur forcée correspondant à une quasi-saturation du transistor de commutation. De cette manière, on sera sûr de fournir un accroissement positif de $Vbe_2$ pour un accroissement positif du courant 1. Le transistor T restera en permanence à la limite de la saturation et le courant consomme par la base sera minimal.

Les courants i et i' n'ont pas besoin d'être importants de sorte que les transistors T1, T2, T3 peuvent rester de petites dimensions. T4 peut être plus important pour participer à la réalisation du gain K.

Un exemple de réalisation de la source de courant commandée 14 est représenté à la figure 2. Elle comprend une source de courant établie classiquement par un miroir de courant à deux transistors T5, T6 alimenté par une borne positive d'alimentation, le transistor T6 recopiant un courant constant connu $i_5$ circulant à travers le transistor T5. Le collecteur du transistor T6 est relié directement aux émetteurs de deux transistors T7 et T8 dont l'un a son collecteur relié à une masse électrique (borne négative de l'alimentation) et l'autre fournit sur son collecteur le courant i de la figure 1.

Le signal de sortie du générateur de créneaux 16 est appliqué en différentiel entre les bases des transistors T7 et T8 pour interrompre ou autoriser le passage du courant i.

La figure 3 représente un exemple possible de réalisation de l'amplificateur de courant 12 de la figure 1. Il comprend un étage darlington NPN T9, T10 (entrée sur la base de T9, sortie sur l'émetteur de T10), avec un transistor d'amplification supplémentaire T11 dont la base et l'émetteur sont reliés respectivement à la base et l'émetteur du transistor T10, et dont le collecteur est relié à la base du transistor T9. Les collecteurs des transistors T9 et T10 sont reliés à une borne d'alimentation positive.

**Revendications**

1. Circuit de commande de commutation d'un transistor de puissance (T) en série avec une charge essentiellement inductive (10), notamment pour une alimentation à découpage ou un circuit de balayage de télévision, comprenant un générateur (16) de créneaux de largeur variable, caractérisé en ce qu'il comporte:
   - une première résistance de faible valeur (R),
   - une deuxième résistance de valeur beaucoup plus importante (r),
   - deux ensembles constituant essentiellement des miroirs de courant comportant chacun un premier transistor (T1, T3) monté en diode et un deuxième transistor (T2, T4) de recopie, les deux transistors, de même type NPN ou PNP dans un même ensemble et de type opposé à ceux de l'autre ensemble, ayant leur bases réunies,
   - la première résistance (R) étant reliée d'une part à l'émetteur du transistor de puissance et d'autre part à la deuxième résistance (r) qui est par ailleurs reliée à l'émetteur du transistor de recopie (T2) du premier miroir de courant; le premier transistor (T1) du premier miroir de courant ayant son émetteur relié à l'émetteur du transistor de puissance et ayant son collecteur en série avec une source de courant (14) commandée en tout ou rien par le générateur de créneaux (16); le transistor de recopie (T2) du premier miroir de courant ayant son collecteur relié au collecteur du premier transistor (T3) du deuxième miroir de courant; les émetteurs des premier et deuxième transistors du deuxième miroir étant réunis mais non ceux du premier miroir, et le collecteur du deuxième transistor du deuxième miroir de courant étant relié à une entrée d'un amplificateur de courant (12) dont la sortie est reliée a la base du transistor de puissance.

2. Circuit de commande selon la revendication 1, caractérisé en ce que le produit du gain en courant ($k1$) du deuxième miroir de courant par le gain en courant ($k2$) de l'amplificateur est lié au rapport r/R de la deuxième résistance à la première par la relation suivante:

$r/R = k_1 k_2 k_3$

ou $k_3$ est une valeur de gain du transistor de puissance qui correspond à un état de quasi saturation de ce transistor.


## Patentansprüche

1. Schaltung zur Schaltsteuerung eines Leistungstransistors (T), der in Reihe mit einer im wesentlichen induktiven Last (10) liegt, insbesondere für eine Zerhackerversorgung oder eine Fernseh-Ablenkschaltung, mit einem Generator (16) für Rechteckimpulse veränderlicher Breite, dadurch gekennzeichnet, daß sie folgende Bestandteile enthält:

- einen ersten, niedrigwertigen Widerstand (R),
- einen zweiten Widerstand (r) mit einem wesentlich höheren Wert,
- zwei Baugruppen, die im wesentlichen Stromspiegel bilden und die je einen als Diode geschalteten ersten Transistor (T1, T3) und einen zweiten Spiegeltransistor (T2, T4) enthalten, wobei die beiden Transistoren, die in einer Baugruppe vom selben Typ NPN oder PNP und in der anderen Baugruppe vom entgegengesetzten Typ sind, mit ihren Basen zusammengeschaltet sind,
- wobei der erste Widerstand (R) einerseits mit dem Emitter des Leistungstransistors und andererseits mit dem zweiten Widerstand (r) verbunden ist, der weiterhin mit dem Emitter des Spiegeltransistors (T2) des ersten Stromspiegels verbunden ist; wobei der erste Transistor (T1) des ersten Stromspiegels mit seinem Emitter an den Emitter des Leistungstransistors angeschlossen ist und sein Kollektor in Reihe mit einer Stromquelle (14) geschaltet ist, die vom Rechteckgenerator (16) ein-aus-gesteuert wird; wobei der Spiegeltransistor (T2) des ersten Stromspiegels an seinem Kollektor mit dem Kollektor des ersten Transistors (T3) des zweiten Stromspiegels verbunden ist; wobei die Emitter des ersten und des zweiten Transistors des zweiten Spiegels miteinander verbunden sind, diejenigen des ersten Spiegels hingegen nicht, und der Kollektor des zweiten Transistors des zweiten Stromspiegels mit einem Eingang eines Stromverstärkers (12) verbunden ist, dessen Ausgang mit der Basis des Leistungstransistors verbunden ist.

2. Steuerungsschaltung nach Anspruch 1, dadurch gekennzeichnet, daß das Produkt der Stromverstärkungsfaktoren des zweiten Stromspiegels (k1) und des Verstärkers (k2) mit dem Verhältnis r/R des zweiten Widerstandes zum ersten Widerstand durch folgende Beziehung verbunden ist:

$r/R = k_1 k_2 k_3$,

wobei $k_3$ ein Verstärkungsfaktor des Leistungstransistors ist, der einem Zustand der fast vollständigen Sättigung dieses Transistors entspricht.


## Claims

1. Circuit for controlling the switching of a power transistor (T) connected in series with an essentially inductive load (10), in particular for a switching power supply or a television deflection circuit, comprising a variable width squarewave generator (16), characterized in that it comprises:

- a first resistor of small value (R),
- a second resistor of much higher value (r),
- two sets essentially forming current mirrors and each comprising a first transistor (T1, T3) mounted as a diode and a second mirror transistor (T2, T4), the two transistors of like type, NPN or PNP, in the same set and of opposite type in the other set, having their bases interconnected,
- the first resistor (R) being connected, on the one hand, to the emitter of the power transistor and, on the other hand, to the second resistor (r) which is further connected to the emitter of the mirror transistor (T2) of the first current mirror; the first transistor (T1) of the first current mirror having its emitter connected to the emitter of the power transistor and having its collector connected in series with the current source (14) which is on/off controlled by the squarewave generator (16); the mirror transistor (T2) of the first current mirror having its collector connected to the collector of the first transistor (T3) of the second current mirror; the emitters of the first and second transistors of the second mirror being interconnected, unlike those of the first mirror, and the collector of the second transistor of the second current mirror being connected to one input of a current amplifier (12) the output of which is connected to the base of the power transistor.

2. Control circuit according to claim 1, characterized in that the product of the current gain (k1) of the second current mirror and the current gain (k2) of the amplifier is related to the ratio r/R of the second resistor to the first by the following relation:

$r/R = k_1 k_2 k_3$

wherein $k_3$ is the gain value of the power transistor which corresponds to the substantially saturated state of this transistor.

FIG_1

FIG_2

FIG_3